# DEMANDE DE BREVET EUROPEEN

(11) **EP 0 798 954 A1**
(43) Date de publication de la demande: **01.10.1997**
(21) Numéro de dépôt: 97400599.3
(22) Date de dépôt: 18.03.1997
(51) Int. Cl.: H05K 7/20, B23K 1/00

(54) **Boîtier de micro-électronique avec système de refroidissement**

(30) Priorité: 26.03.1996 FR 9603717
(71) Demandeur: THOMSON-CSF, 75008 Paris (FR)
(72) Inventeur: Assouad, Yannick, Thomson-CSF SCPI, 94117 Arcueil Cedex (FR); Barriere, Jean-Michel, Thomson-CSF SCPI, 94117 Arcueil Cedex (FR); Bellin, Bruno, Thomson-CSF SCPI, 94117 Arcueil Cedex (FR); Bonniau, Philippe, Thomson-CSF SCPI, 94117 Arcueil Cedex (FR); Malgouyres, Michel, Thomson-CSF SCPI, 94117 Arcueil Cedex (FR)
(74) Mandataire: Beylot, Jacques

(57) **Abrégé**

La présente invention concerne les boîtiers de micro-électronique, notamment hyperfréquence, intégrant des composants à forte dissipation thermique, pour une utilisation dans le domaine aéroporté. Elle est relative plus particulièrement aux boîtiers en titane ou en composite SlC/aluminium à refroidissement amélioré. Elle consiste à équiper au moins une paroi (11) d'un boîtier, d'une surface d'échange thermique constituée d'une feuille d'aluminium (19, 20) plissée en accordéon et brasée par ses pliures sur un placage d'aluminium (21) déposé sur ladite paroi (11). Le boîtier est avantageusement pourvu d'un système de refroidissement à canaux creusés dans une paroi et parcourus par un fluide réfrigérant, la ou lesdites surfaces d'échange thermique en feuille d'aluminium (19, 20) plissée en accordéon étant logées à l'intérieur des canaux (16, 17) et brasées à un placage d'aluminium (21) déposé sur les parois intérieures de ceux-ci.

## Description

La présente invention concerne les boîtiers de micro-électronique, notamment hyperfréquence, intégrant des composants à forte dissipation thermique, pour une utilisation dans le domaine aéroporté.

Les circuits de micro-électronique hyperfréquence mettent en uvre des plaquettes de substrat isolant brasées à une semelle métallique faisant souvent partie d'un boîtier et constituant à la fois un plan conducteur de masse pour les hyperfréquences et un radiateur pour l'évacuation des calories. Lorsqu'une forte dissipation thermique est envisagée, on peut prévoir dans la semelle métallique des canaux pour la circulation d'un liquide de refroidissement. Ces canaux sont creusés dans la face de la semelle opposée au substrat et refermés par un couvercle étanche.

La semelle doit avoir un coefficient de dilatation proche de celui du substrat isolant pour limiter les contraintes thermomécaniques s'exerçant au niveau de la brasure avec le substrat isolant, une forte conductivité thermique pour transférer les calories et une faible densité pour la légèreté.

Le substrat isolant est, en général, une plaquette en céramique d'alumine ayant un coefficient de dilatation linéaire de 6,5 10⁻⁶ °C⁻¹tandis que la semelle ou le boîtier est en un alliage de fer, nickel et cobalt connu sous l'appellation "dilver", en aluminium, en titane, ou encore en un composite de fibres de carbure de silicium et d'aluminium connue sous l'appellation composite SIC/aluminium.

Un boîtier en dilver avec substrat d'alumine a l'avantage d'autoriser l'emploi de grand substrat car le coefficient de dilatation du dilver est très proche de l'alumine. Il est par contre lourd, donc mal adapté à l'environnement aéroporté la densité du dilver étant de l'ordre de 8,3 g/cm³ et peu efficace quant à l'évacuation des calories, sa conduction thermique n'étant que de 17 W/m/°C.

Un boîtier en aluminium avec substrat d'alumine n'est possible qu'avec des tailles de substrat très faible, au plus 10 × 10 mm, étant donné la grande différence des coefficients linéaire de dilatation, 23 10⁻

Un boîtier en titane avec substrat d'alumine est un bon compromis en terme de coefficients de dilatation, le coefficient de dilatation linéaire du titane étant de 8,5 10⁻⁶°C⁻¹ contre 6,5 10⁻⁶°C⁻¹ pour l'alumine, et en terme de masse, la densité du titane n'étant que de 4,54 g/cm³. Par contre il reste médiocre du point de vue de la conduction thermique qui n'est que de 20W/m/°C.

Un boîtier en composite SIC/aluminium permet en théorie de répondre aux trois exigences de faible coefficient de dilatation, faible densité et forte conduction thermique. Cependant, les technologies de mise en oeuvre des composites SIC/aluminium sont mal maîtrisées en raison de la dureté du matériau. En outre, la fermeture hermétique d'un boîtier en composite SIC/aluminium est délicate car on ne sait pas souder facilement ce matériau.

La présente invention a pour but d'améliorer les boîtier en titane ou en composite SIC/aluminium avec substrat d'alumine du point de vue du refroidissement.

Elle a pour objet un boîtier de micro-électronique en titane ou en composite SIC/aluminium, avec un système de refroidissement sur une paroi, pourvu d'au moins une surface d'échange thermique constituée d'une feuille d'aluminium plissée en accordéon et brasée par ses pliures sur un placage d'aluminium déposé sur ladite paroi.

Avantageusement, le système de refroidissement comporte des canaux creusés dans la paroi du boîtier et parcourus par un fluide réfrigérant. La surface d'échange thermique en feuille d'aluminium plissée en accordéon est alors logée à l'intérieur des canaux et brasée à un placage d'aluminium déposé sur les parois intérieures de ceux-ci.

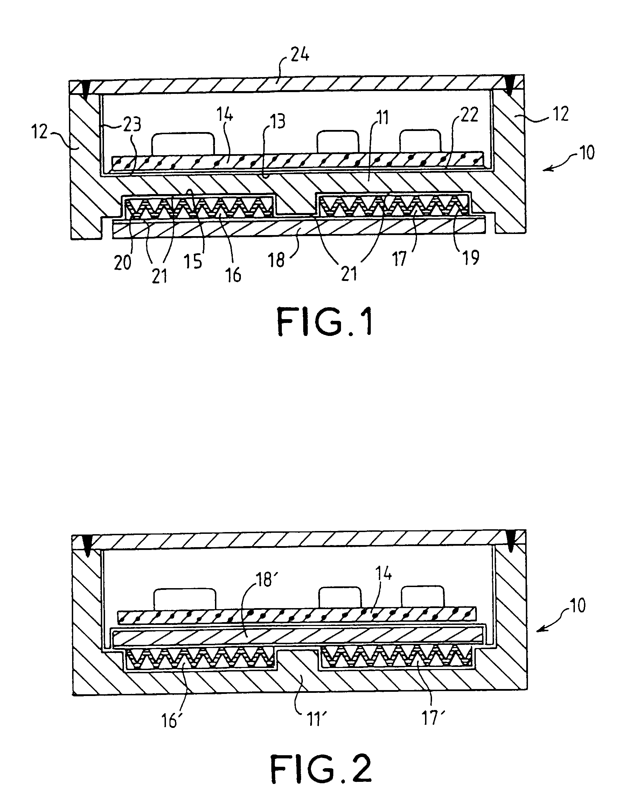

D'autres caractéristiques et avantages de l'invention ressortiront de la description de deux modes de réalisation donnés à titre d'exemple. Cette description sera faite ci-après en regard du dessin dans lequel des figures 1 et 2 montrent des coupes de deux boîtiers selon l'invention.

On distingue sur la figure 1 un boîtier pour micro-électronique constitué d'une forme en titane 10 creusée d'une cavité, avec un fond 11 et des parois latérales 12. La surface supérieure 13 du fond 11 est plate et vient au contact de la surface plane de la face inférieure d'une mince plaquette isolante en céramique d'alumine 14 portant sur sa face supérieure des pistes et composants hyperfréquence. La surface inférieure du fond 15 est creusée de deux canaux 16 et 17 en boucle, ouvert sur le dessous, refermés par un couvercle brasé 18 et communicant avec des orifices non représentés qui sont pratiqués dans une paroi latérale 12 pour permettre la circulation d'un fluide réfrigérant.

Pour limiter les contraintes thermomécaniques, le couvercle 18 des canaux 16 et 17 est en titane comme le boîtier. Le refroidissement est amélioré au moyen de feuilles plissées en accordéon 19, 20 insérées dans les canaux 16 et 17, leurs pliures parallèles à la direction de circulation du fluide, et maintenues en intime contact thermique avec le fond 11 du boîtier. Ces feuilles 19, 20 fractionnent la veine de fluide sur une partie de son trajet dans les canaux 16 et 17, en une multitude de filets et augmentent de façon considérable la surface d'échange thermique. Elles sont en aluminium en raison de la meilleure conductivité thermique de ce métal par rapport au titane. Il se pose alors le problème de la fixation de ces feuilles d'aluminium 19, 20 à la paroi de titane des canaux 16, 17 pour un bon contact thermique. Celui-ci est résolu au moyen d'un placage d'aluminium 21 réalisé à la fois sur la face inférieure 15 du fond 11 du boîtier et sur les parois du couvercle 18 en titane. Ce placage d'aluminium 21 permet un brasage des pliures des feuilles d'aluminium 18 et 19 au contact de fond 11 du boîtier et du couvercle 18 ainsi qu'un brasage du couvercle 18 sur le fond 11 du boîtier pour un scellement étanche des parois des canaux 16, 17, les brasages s'effectuant avec de l'aluminium comme métal d'apport.

Le contact thermique entre la face supérieure 13 du fond 11 du boîtier et la plaquette isolante en céramique d'alumine 14 supportant les pistes et composants hyperfréquence est assuré par un brasage étain-plomb-argent ou indium-plomb 22, de toute la surface inférieure de la plaquette en céramique 13 sur la surface supérieure 13 du fond 11 du boîtier soumis au préalable à un placage à l'argent 23.

Un couvercle 24 en titane qui referme le logement de l'électronique hyperfréquence est soudé aux parois 12 du boîtier par laser.

La fabrication du boîtier d'électronique hyperfréquence qui vient d'être décrit se fait par une succession d'opérations qui consiste en :
- une élaboration de la forme en titane 10 du boîtier par exemple par moulage suivi d'une rectification et d'un perçage des différents orifices,
- découpe aux dimensions des couvercles en titane 18 et 24,
- placage d'aluminium par déposition de vapeur ionique sous vide IVD (lonic Vapor Deposition) de la forme 10 du boîtier et du couvercle 18 de canaux en titane,
- montage des feuille d'aluminium pliée en accordéon 19, 20 dans les canaux 16, 17 du fond du boîtier,
- mise en place du couvercle 18 de canaux avec une feuille de brasure intercalaire en aluminium,
- réalisation des brasures d'aluminium par étuvage sous vide et maintien par pression du couvercle 18 des canaux contre le fond de la forme 10 du boîtier,
- mise en place d'un vemis d'épargne sur le joint de brasage en aluminium du couvercle 18 des canaux et obturation provisoire des orifices,
- décapage du placage d'aluminium apparent et argenture de la forme 10 du boîtier et du couvercle 24 de logement,
- brasage étain-plomb-argent ou indium-plomb, à la surface supérieure 13 du fond 11 du boîtier, d'une plaque isolante en céramique d'alumine 14 supportant des éléments hyperfréquence, et
- fermeture du boîtier par soudage au laser du couvercle 24 de logement sur les parois 12 du boîtier.

La figure 2 illustre une variante de boîtier dans laquelle les canaux 16', 17' du fluide de refroidissement ont été creusés sur le fond 11' du boîtier 20 et non pas en dessous. Le couvercle en titane 18' refermant les parois des canaux 16', 17' vient alors à l'intérieur et au fond du logement de l'électronique hyperfréquence, la plaquette isolante en céramique d'alumine 14 lui étant brasée dessus. Le processus de fabrication est inchangé, mis à part la nouvelle disposition du couvercle 18' des canaux.

On peut également utiliser une forme de boîtier en composite SIC/aluminium au lieu d'une forme de boîtier en titane. Le composite SIC/aluminium est constitué d'une matrice en particules de céramique en carbure de silicium noyée dans de l'aluminium. Il a pour caractéristiques de répondre aux exigences d'un coefficient de dilatation linéaire proche de celui de l'alumine, et une densité et une conductivité thermique proches de celles de l'aluminium. Il est donc tout à fait approprié pour la réalisation de boîtiers pour éléments électroniques hyperfréquence montés sur substrats isolants en céramique d'alumine. Cependant, il est difficile à usiner en raison de sa dureté et également difficile à souder. Grâce au placage d'une couche d'aluminium en surface par dépôt de vapeur ionique sous vide IVD, on rend possible le brasage à l'aluminium de matériaux tels que des feuilles d'aluminium ou une plaque de titane.

## Revendications

1. Boîtier de micro-électronique en titane ou en composite SIC/aluminium, avec un système de refroidissement (16, 17) sur une paroi (11), caractérisé en ce qu'il est pourvu d'au moins une surface d'échange thermique constituée d'une feuille d'aluminium (19, 20) plissée en accordéon et brasée par ses pliures sur un placage d'aluminium (21) déposé sur ladite paroi (11).

2. Boîtier selon la revendication 1, avec un système de refroidissement comportant des canaux (16, 17) creusés dans la paroi du boîtier et parcourus par un fluide de réfrigérant, caractérisé en ce que la ou lesdites surfaces d'échange thermique en feuille d'aluminium (19, 20) plissée en accordéon sont logées à l'intérieur des canaux (16, 17) et brasées à un placage d'aluminium (21) déposé sur les parois intérieures de ceux-ci.

3. Boîtier selon la revendication 2, caractérisé en ce que les canaux (16, 17) du système de refroidissement sont creusés sous le fond (11) du boîtier, ouverts sur le dessous, et refermés de façon étanche par un couvercle (18).

4. Boîtier selon la revendication 2, caractérisé en ce que les canaux (16', 17') du système de refroidissement sont creusés sur le fond (11') du boîtier, ouverts sur le dessus et refermés de manière étanche par un couvercle (18').

5. Boîtier selon la revendication 3 ou la revendication 4, caractérisé en ce que les parois des canaux (16, 17, 16', 17')) creusés dans le fond (11, 11') du boîtier et le couvercle (18, 18') des canaux (16, 17, 16', 17') sont revêtus d'un placage d'aluminium (21) autorisant un brasage à l'aluminium du couvercle (18, 18') sur le fond (11, 11') du boîtier et des feuilles d'aluminium (19, 20) plissées en accordéon aux parois intérieures des canaux (16, 17, 16', 17').

6. Boîtier selon la revendication 1, caractérisé en ce que ledit placage d'aluminium est réalisé par déposition de vapeur ionique sous vide.
